# FASCICULE DE BREVET EUROPEEN

(11) **EP 1 240 619 B1**
(45) Date de publication et mention de la délivrance du brevet: **25.02.2004**
(21) Numéro de dépôt: 00981561.4
(22) Date de dépôt: 22.12.2000
(51) Int. Cl.: G06K 19/04, G06K 19/077

(54) **ETIQUETTE ELECTRONIQUE**
ELEKTRONISCHES ETIKETT
ELECTRONIC LABEL

(30) Priorité: 23.12.1999 CH 236199; 28.01.2000 CH 167002000; 03.02.2000 CH 216002000
(43) Date de publication de la demande: 18.09.2002
(73) Titulaire: NagraID S.A., 2301 La Chaux-de-Fonds (CH)
(72) Inventeur: DROZ, François, CH-2300 La Chaux-de-Fonds (CH)
(74) Mandataire: Wenger, Joel-Théophile
(86) Numéro de dépôt international: PCT/IB2000/001952
(87) Numéro de publication internationale: WO 2001/048687

(56) Documents cités:
- EP-A- 0 288 676
- WO-A-93/12513
- DE-A- 19 613 491
- FR-A- 2 689 663
- US-A- 5 844 244

## Description

La présente invention concerne une étiquette électronique, en particulier une étiquette électronique souple.

On entend par étiquette électronique, un ensemble comprenant au moins un support souple, une antenne et une puce électronique. Cet ensemble peut comporter plusieurs antennes ou plusieurs puces selon les besoins. On les trouve en forme de bouton, dans des cartes à puce, voire dans des étiquettes à bagages. Grâce à leurs antennes, elles peuvent communiquer avec un lecteur distant. L'antenne sert non seulement comme moyen de communication, mais peut servir également à produire l'énergie nécessaire à alimenter la puce électronique.

Selon les modes de réalisation, l'antenne est rapportée sur le support souple ou directement gravée ou découpée sur ce même support.

Il existe de nombreuses puces qui diffèrent par leurs fonctionnalités, par exemple certaines ne permettant que la lecture d'information alors que d'autres permettent la mémorisation et la modification de leur mémoire. Ces dernières sont utilisées entre autre pour des applications de porte-monnaie électronique qui bien entendu, doit être diminué en fonction de la consommation de l'utilisateur.

Le sujet de la présente invention se concentre particulièrement sur des étiquettes électroniques souples. On les trouve dans des bracelets, des tickets de spectacle ou des badges, voire même noyées dans l'étoffe d'habit. Elles peuvent être adjointes à un objet tel qu'un vêtement ou prendre la forme de l'objet, par exemple le support souple fait office de bracelet.

Si les antennes fabriquées en un ensemble de fils de cuivre fins, se prêtent docilement aux flexions et autres torsions, la puce électronique quant à elle, a besoin d'une zone rigide pour son implantation. En effet, la puce en silicium est fragile et c'est pourquoi elle est enrobée dans une résine qui va la protéger des agressions mécaniques et contre les attaques chimiques (corrosion). Cette résine va également protéger les contacts entre la puce et l'antenne.

Le document US5844244 reflète le préambule de la revendication 1, et décrit une étiquette électronique comprenant une puce et une antenne incorporées dans une matière diélectrique. Cette étiquette peut être fixée sur un support quelconque de façon amovible et interchangeable. Dans cette réalisation, la matière diélectrique est le seul élément de protection de la puce qui peut se révéler insuffisant dans de nombreuses applications à cause de son manque de rigidité.

C'est pourquoi la zone de la puce reste une région qui ne peut se plier sous peine de voir la puce, ou ses contacts se casser. Cette zone peut mesurer environ 5 à 7 mm de diamètre du fait de l'enrobage de la puce. L'enrobage de la puce constitue une opération supplémentaire à la fabrication et renchérit le prix de revient d'une telle étiquette.

Le but de la présente invention est d'une part de réduire la zone rigide sur un support souple tout en assurant la protection de la puce.

Ce but est atteint par une étiquette électronique souple, comprenant au moins un support souple, une antenne et une puce électronique, ladite puce étant montée sur le support souple et raccordée à l'antenne. Cette étiquette se caractérise par le fait que la protection de la puce est assurée par un élément rigide rapporté sur le support.

Ainsi, ce n'est plus l'enrobage de la puce qui assure sa rigidité mais un élément rigide qui est placé soit au dessus, soit au dessous de la puce. Cet élément peut servir avantageusement d'élément décoratif.

Par élément rigide, il peut s'agir par exemple d'une extension d'un élément rigide déjà monté sur le support souple tel qu'un élément de fixation ou fermoir. De cette manière, le fermoir d'un bracelet peut être rallongé pour recouvrir la puce montée sur la partie souple du bracelet. Ceci s'applique pour tous type de fermoir, que ce soit un bracelet de montre avec ardillon ou un fermoir mono-usage pour personne hospitalisée. Il existe toujours une partie rigide qui peut faire office de protection pour la puce.

En l'absence de fermoir, cet élément rigide peut également prendre la forme d'un dôme rigide indépendant qui vient recouvrir l'emplacement de la puce, que ce soit sur l'une ou l'autre des faces du support souple, et qui dispose de pieds traversant ce support souple pour se clipser dans une plaquette à cet effet.

Selon une autre forme de réalisation, le dôme rigide est placé sous la puce électronique.

D'autres formes ou moyens de montage peuvent être imaginés tels que le collage, le soudage ou la déformation du pied à chaud.

Dans certaines applications, il peut être intéressant de monter la puce plus tard, voire la changer selon les besoins. Pour cela, la. présente invention s'applique également à un élément rigide incluant la puce électronique, cette dernière venant se connecter sur l'antenne par l'intermédiaire de plages de contacts prévues à cet effet.

L'invention sera mieux comprise grâce à la description détaillée qui va suivre et qui se réfère aux dessins annexés qui sont donnés à titre d'exemple nullement limitatif, dans lesquels :
la figure 1 représente un bracelet avec fermoir à ardillon incluant une étiquette électronique selon l'invention;
la figure 2 représente un bracelet souple incluant une étiquette électronique et un élément rigide rapporté;
la figure 3 représente une vue en coupe du bracelet souple de la figure 2;
la figure 4 représente une antenne d'étiquette électronique sur laquelle peut ce connecter une puce électronique;
la figure 5 représente le montage d'une puce électronique venant se connecter sur l'antenne montée dans un support souple.

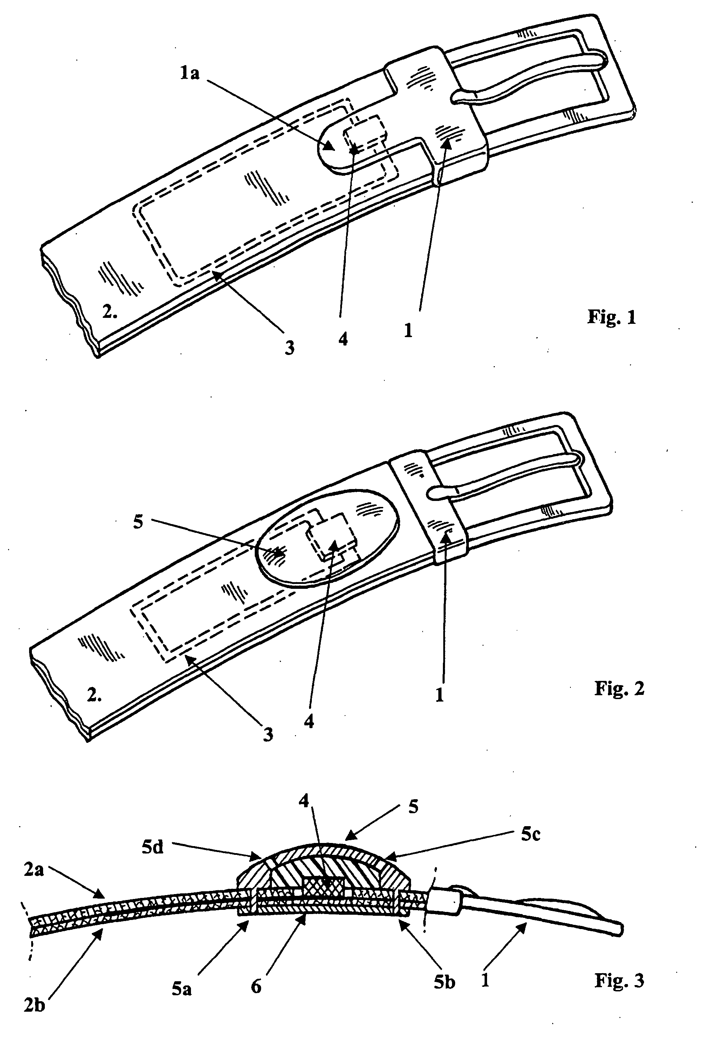

Sur la figure 1, on distingue en pointillé l'antenne **3** noyée dans le bracelet souple **2**. L'antenne est généralement réalisée entre deux couches de tissé pour la protéger mécaniquement. La puce électronique **4** est placée le long de l'antenne **3** et connectée à celle-ci généralement par deux fils d'or. Le fermoir **1** est rigide et, dans cet exemple, dispose d'une protubérance **1a** qui recouvre l'endroit ou la puce **4** est placée.

D'autres formes de fermoir peuvent être utilisés par exemple avec un clips dont une partie serait prolongée pour se situer juste au-dessus de la puce électronique.

Lors de l'utilisation de bracelet de faible coût, ce dernier peut n'avoir qu'une seule couche; l'antenne ainsi que la puce électronique sont appliquées sur l'intérieur du bracelet et selon l'invention, une partie du fermoir recouvre la puce électronique.

La figure 2 montre une exécution dans laquelle l'on ne souhaite pas utiliser une partie du fermoir **1** pour protéger la puce **4**. Dans ce cas, on utilise un élément **5** rapporté qui se place au-dessus de la puce **4**. Cet élément **5**, ici en forme de dôme, s'applique sur le support souple **2**. On notera qu'il peut être maintenu de diverses manières, soit par collage ou thermo-collage, soit par clipsage. Ce dôme peut également servir de support publicitaire, par exemple en ayant la forme du logo de l'entreprise.

Cette manière de monter l'étiquette électronique s'applique à tout support souple et ne se limite pas à des bracelets. On peut incorporer un tel ensemble dans un ticket d'avion ou de théâtre à l'intérieur d'un habit, dans un dossard de coureur.

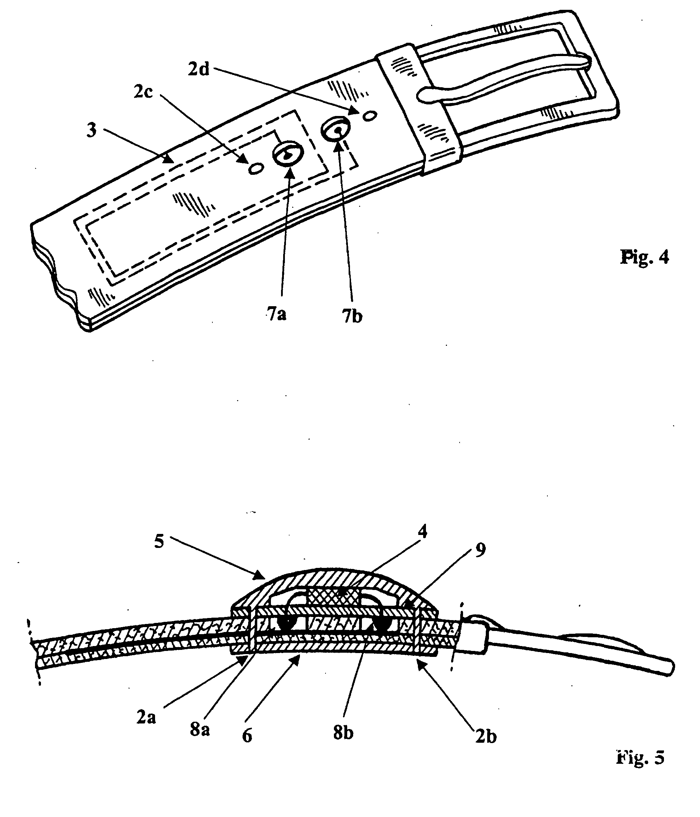

La figure 3 nous montre une coupe transversale d'un exemple d'exécution d'un tel élément rigide. On peut distinguer la partie supérieure du dôme **5** qui dispose de deux pieds **5a** et **5b** qui traversent le support souple **2** pour se clipser dans une plaquette **6**. Le support souple **2** est composé d'une couche supérieure **2a** et d'une couche inférieure **2b.** L'antenne **3** est placée entre ces deux couches et connectées à la puce électronique **4**. Dans une forme d'exécution non représentée, la couche supérieure recouvre la puce électronique. Dans une autre forme de réalisation telle que représentée à la figure 3, la couche supérieure dispose d'un orifice laissant passer la puce électronique **4**. Cette dernière configuration permet d'obtenir une épaisseur réduite.

Selon une autre forme de réalisation, le dôme **5** dispose de deux orifices **5c** et **5d** destinés à remplir l'espace sur la puce **4** d'un matériau de remplissage tel qu'une résine epoxy ou un silicone. Ceci présente l'avantage de protéger la puce **4** de la corrosion due à l'humidité, la transpiration ou des agents nettoyants corrosifs. La résine est injectée par un premier orifice **5c** et lorsque l'espace sous le dôme **5** est rempli, la résine en excédent ressort par le deuxième orifice **5d.**

Selon une variante de cette exécution, le dôme **5** est préalablement rempli d'une goutte de résine avant d'être mis en place. L'excédent de résine s'échappe par un orifice prévu à cet effet

La figure 4 montre une exécution du support souple **2** incluant l'antenne **3** mais sans la puce électronique **4**. Le support souple **2** laisse apparaître deux zones **7a** et **7b** dans lesquelles les deux extrémités conductrices de l'antenne **3** sont accessibles. Selon les besoins, ces zones sont revêtues d'un matériau conducteur (or, aluminium, cuivre ou carbone). Dans le but de faciliter le montage, deux orifices **2c** et **2d** destinés au montage sont placés de part et d'autres des évidements

L'assemblage de cette exécution est illustré à la figure 5. L'élément rigide **5** comprend la puce électronique **4**. Ainsi, c'est par l'action de la mise en place de la protection **5** que la puce va être en contact avec l'antenne et l'étiquette devenir ainsi opérationnelle. A cet effet, selon une forme d'exécution, l'élément rigide **5** comprend un substrat 9 sur lequel est placée la puce électronique. Egalement sur ce substrat, se trouvent les deux pistes conductrices **8a** et **8b** qui viennent se placer en face des deux évidements **7a** et **7b** reliés à l'antenne **3**. Ces pistes peuvent être réalisées par des dépôts de carbone par exemple. Le montage de l'élément rigide **5** par des pieds **5a** et **5b** traversant le support souple est avantageux car il assure en même temps le positionnement des contacts entre l'antenne et la puce.

Afin d'améliorer la tenue et la conductivité électrique entre la puce et l'antenne, il peut être appliqué une colle conductrice sur les contacts servant de liant conducteur.

D'autres formes d'exécution de la puce ne nécessitent pas la présence du substrat **9**. Il est connu des puces électroniques, dénommées "flip chip" qui incluent des reliefs destinés à la connexion. Grâce à ces reliefs, la puce peut être directement appliquée sur le support souple et se connecter ainsi à l'antenne. Selon une autre variante, il est connu d'appliquer un film conducteur sur la puce, film qui assure la conduction entre la puce et l'antenne. Les zones conductrices sont délimitées dans ce type d'exécution, par traitement thermique.

Selon une variante de cette exécution, l'élément rigide **5** comprend des accessoires tels qu'une pile, vibreur, LED ou transducteur, pour les applications de cette étiquette.

Les bracelets à utilisation unique sont utilisés pour des applications telles que le contrôle d'accès à des spectacles ou l'identification de patient d'un hôpital. Ils sont conçus pour que l'ouverture d'un tel bracelet ne peut se faire qu'en le détruisant. Dans cette optique, il est important que l'authentification faite par l'étiquette électronique puisse également s'interrompre au même titre que l'authentification visuelle.

Selon une variante de l'invention, le fermoir, dont une partie recouvre la puce électronique, est agencé pour détruire la puce ou l'antenne en cas de tentative d'ouverture. Pour cela, plusieurs variantes peuvent être utilisées.

Selon une première variante, la partie du fermoir recouvrant la puce est collée à cette dernière. Ainsi, en cas d'ouverture forcée du fermoir, la puce électronique est arrachée de son support souple et, sans contact avec l'antenne, ne peut plus fonctionner. La colle de maintien de la puce sur le support souple a un pouvoir adhérant inférieur à la colle reliant la puce au fermoir.

Selon une deuxième variante, la partie du fermoir protégeant la puce dispose de deux ergots qui traversent le bracelet souple. Les orifices du bracelet souple sont rapprochés et entre eux passe au moins un des conducteurs de l'antenne. Les deux ergots sont élargis à leurs extrémités afin de les empêcher de ressortir. Cette fonction est assurée soit par des pièces rapportées par clipsage, soit obtenue par déformation de l'ergot, par échauffement par exemple.

Lors d'une tentative d'ouverture forcée, l'ergot ne peut s'échapper de son orifice sans provoquer le déchirement du passage entre les deux orifices et provoque ainsi l'interruption définitive de l'antenne et par conséquent, l'étiquette n'est plus opérationnelle.

Bien que ce type de sécurité est bien adaptée aux agressions dirigées contre le fermoir, il existe toujours pour le fraudeur, la possibilité de couper le bracelet pour le transmettre à un tiers qui pourra ainsi s'identifier grâce à la fonction électronique de l'étiquette.

Afin d'empêcher ce type d'agissement, il est proposé, selon une forme particulière de l'invention, qu'au moins une spire de l'antenne est déployée sur toute la longueur de l'étiquette électronique. Ainsi, il n'est pas possible de couper ce type de bracelet sans interrompre l'antenne et par là même, le fonctionnement du module électronique.

Il n'est pas nécessaire que toute l'antenne se déploie sur la longueur du bracelet, il suffit qu'une spire passe d'une des parties du fermoir à l'autre sans laisser de passage permettant l'interruption du bracelet.

Selon une variante de cette exécution, la puce électronique dispose de deux connections qui doivent impérativement être reliées entre-elles pour permettre le fonctionnement de cette puce. Ces deux connections sont reliées à un conducteur qui parcours toute la longueur de l'étiquette électronique et garantit que toute coupure de cette étiquette électronique provoque immanquablement l'interruption du conducteur et par conséquent, l'arrêt de la puce.

Cette même fonction du fil conducteur peut être utilisée pour volontairement rendre l'étiquette inopérante. On peut imaginer un ticket d'avion dont une partie est prédécoupée mais tout en laissant passer le fil conducteur. Lors de la validation dudit ticket, l'opérateur découpe le coupon à l'endroit prévu à cet effet et provoque l'interruption du fil conducteur. Cette opération rend le module électronique inopérant.

Cette partie destinée à la séparation peut être obtenue par pré-découpage ou par affaiblissement d'une région de l'étiquette. En effet, l'épaisseur du support souple peut être réduite afin de faciliter la découpe ultérieure à cet endroit.

## Revendications

1. Etiquette électronique souple, comprenant au moins un support souple (2), une antenne (3) et une puce électronique (4), ladite puce (4) étant raccordée à l'antenne (3), **caractérisée en ce que** la protection de la puce (4) est assurée par un élément rigide (1,5) rapporté sur au moins une des faces du support.

2. Etiquette électronique selon la revendication 1, **caractérisée en ce que** l'élément rapporté rigide (1) est une partie (1a) d'un élément servant de fermeture ou à la fixation de l'étiquette.

3. Etiquette électronique selon la revendication 1, **caractérisée en ce que** l'antenne comprend deux zones (7a et 7b) d'accès électrique à ses pôles et **en ce que** l'élément rigide rapporté (5) comprend la puce électronique (4) ainsi que deux zones de connexion électrique (8a et 8b) destinées, lors du montage de l'élément rigide (5) à venir en contact avec les deux zones (7a et 7b) de l'antenne (3).

4. Etiquette électronique selon la revendication 3 **caractérisée en ce que** l'élément rigide (5) comprend des accessoires tels qu'une pile, vibreur, LED ou transducteur.

5. Etiquette électronique selon les revendications 1 et 3, **caractérisée en ce que** l'élément rapporté (1 ) est un élément (5) indépendant propre à cet usage.

6. Etiquette électronique selon la revendication 5, **caractérisée en ce que** l'élément indépendant (5) est monté sur le support souple (2) par collage, soudage ou par clipsage.

7. Etiquette électronique selon les revendications 5 et 6, **caractérisée en ce que** l'élément indépendant (5) est rempli d'une substance recouvrant la puce (4).

8. Etiquette électronique selon les revendications 1 à 7, **caractérisée en ce qu'**elle comprend au moins un fil conducteur se déployant sur toute sa longueur et dont l'interruption provoque l'arrêt du fonctionnement de ladite étiquette.

9. Etiquette électronique selon la revendication 8, **caractérisée en ce que** ce fil conducteur fait partie de l'antenne (3).

10. Etiquette électronique selon la revendication 8, **caractérisée en ce que** ce fil conducteur est relié, par ses deux extrémités, à la puce électronique (4).

11. Etiquette électronique selon les revendications 8 à 10, **caractérisée en ce que** ce fil conducteur traverse une zone de séparation à solidité réduite.

12. Etiquette électronique selon les revendications 1 à 11, **caractérisée en ce que** l'élément rigide (1) dispose de moyens pour provoquer la destruction de la puce (4) et/ou de l'antenne (3) lors de la séparation de l'élément rigide (1) du support souple (2).

13. Etiquette électronique selon la revendication 12, **caractérisée en ce que** ces moyens sont constitués d'une colle placée entre la puce (4) et l'élément rigide (1), et dont le pouvoir adhérant est supérieur au liant placé entre la puce (4) et le support souple (2).

14. Etiquette électronique selon la revendication 12, **caractérisée en ce que** le support souple (2) dispose d'au moins deux orifices entre lesquels passe au moins un des conducteurs de l'antenne (3), et **en ce que** ces moyens comprennent au moins deux ergots solidaires de l'élément rigide (1) et traversant lesdits orifices, lesdits ergots étant élargis à leurs extrémités soit par l'adjonction d'une pièce rapportée, soit par déformation.

## Patentansprüche

1. Weiches elektronisches Etikett mit zumindest einem weichen Träger (2), einer Antenne und einem elektronischen Chip (4), wobei dieser Chip an die Antenne (3) angeschlossen ist, **dadurch gekennzeichnet, dass** der Schutz des Chips (4) durch ein starres, auf zumindest eine der Seiten des Trägers aufgesetztes Element (1, 5) gewährleistet ist.

2. Elektronisches Etikett nach Anspruch 1, **dadurch gekennzeichnet, dass** das starre, aufgesetzte Element (1) ein Teil (1a) eines Elements ist, das als Verschluss oder für die Befestigung des Etiketts dient.

3. Elektronisches Etikett nach Anspruch 1, **dadurch gekennzeichnet, dass** die Antenne zwei Bereiche (7a und 7b) elektrischen Zugriffs auf ihre Anschlussklemmen hat und dass das starre, aufgesetzte Element (5) einen elektronischen Chip sowie zwei Bereiche (8a und 8b) elektrischer Kontaktierung hat, die dafür bestimmt sind, bei der Montage des starren Elements (5) mit den beiden Bereichen (7a und 7b) der Antenne (3) in Berührung zu treten.

4. Elektronisches Etikett nach Anspruch 3, **dadurch gekennzeichnet, dass** das starre Element (5) Zubehör wie eine Batterie, einen Zerhacker, eine LED oder einen Signalwandler umfasst.

5. Elektronisches Etikett nach Ansprüchen 1 und 3, **dadurch gekennzeichnet, dass** das aufgesetzte Element (1) ein unabhängiges, für diese Anwendung geeignetes Element (5) ist.

6. Elektronisches Etikett nach Anspruch 5, **dadurch gekennzeichnet, dass** das unabhängige Element (5) durch Kleben, Schweissen oder Anklippen auf den weichen Träger (2) montiert wird.

7. Elektronisches Etikett nach Ansprüchen 5 und 6, **dadurch gekennzeichnet, dass** das unabhängige Element (5) mit einer den Chip (4) überdeckenden Substanz gefüllt ist.

8. Elektronisches Etikett nach Ansprüchen 1 bis 7, **dadurch gekennzeichnet, dass** es zumindest einen Leiterdraht umfasst, der sich über seine ganze Länge erstreckt und dessen Durchtrennung den Abbruch des Funktionierens dieses Etiketts hervorruft.

9. Elektronisches Etikett nach Anspruch 8, **dadurch gekennzeichnet, dass** dieser Leiterdraht einen Teil der Antenne (3) bildet.

10. Elektronisches Etikett nach Anspruch 8, **dadurch gekennzeichnet, dass** dieser Leiterdraht mit seinen beiden Enden an den elektronischen Chip (4) angeschlossen ist.

11. Elektronisches Etikett nach Ansprüchen 8 bis 10, **dadurch gekennzeichnet, dass** dieser Leiterdraht eine Trennzone reduzierter Stabilität quert.

12. Elektronisches Etikett nach Ansprüchen 1 bis 11, **dadurch gekennzeichnet, dass** das starre Element (1) über Mittel verfügt, um bei Abtrennung des starren Elements (1) vom weichen Träger (2) die Zerstörung des Chips (4) und/oder der Antenne (3) zu bewirken.

13. Elektronisches Etikett nach Anspruch 12, **dadurch gekennzeichnet, dass** diese Mittel aus einem zwischen dem Chip (4) und dem starren Element (1) befindlichen Kleber bestehen, dessen Klebkraft grösser als die des zwischen dem Chip (4) und dem weichen Träger (2) befindlichen Bindemittels ist.

14. Elektronisches Etikett nach Anspruch 12, **dadurch gekennzeichnet, dass** der weiche Träger (2) über zumindest zwei Löcher verfügt, zwischen denen zumindest einer der Leiter der Antenne (3) verläuft, und dadurch, dass diese Mittel zumindest zwei fest mit dem starren Element (1) verbundene, durch diese Löcher hindurchgehende Vorsprünge umfassen, die an ihren Enden entweder durch Anfügen eines angesetzten Stücks oder durch Verformung verbreitert sind.

## Claims

1. A flexible electronic label that comprises at least a flexible support (2), an antenna (3), and an electronic chip (4), said chip (4) being connected to the antenna (3), **characterized in that** the protection of the chip (4) is ensured by a rigid element (1, 5) added on at least one of the faces of the support.

2. An electronic label according to Claim 1, **characterized in that** the added element (1) is a part (1 a) of an element that serves as a closing element or fixation of the label.

3. An electronic label according to Claim 1 **characterized in that** the antenna comprises two zones (7 a and 7 b) of electric access to its poles and **in that** an added rigid element (5) comprises the electronic chip (4) as well as two zones of electric connection (8 a and 8 b) destined, during the assembly of the rigid element (5), to contact with the two zones (7 a and 7 b) of the antenna (3).

4. An electronic label according to Claim 3, **characterized in that** the rigid element (5) comprises accessories such as a battery, a vibrator, a LED or transducer

5. An electronic label according to Claims 1 and 3, **characterized in that** the added element (1) is an independent element (5) specific for this use.

6. An electronic label according to Claim 5, **characterized in that** the independent element (5) is assembled on the flexible support (2) by gluing, welding, or by engagement.

7. An electronic label according to Claims 5 and 6, **characterized in that** the independent element (5) is filled with a substance that covers the chip (4).

8. An electronic label according to Claims 1 to 7, **characterized in that** it comprises at least one conductive wire that is displayed along all its length and whose interruption produces the stopping of the functioning of said label.

9. An electronic label according to Claim 8, **characterized in that** this conductive wire is a part of the antenna (3).

10. An electronic label according to Claim 8, **characterized in that** this conductive wire is linked by its two ends to the electronic chip (4).

11. An electronic label according to Claims 8 to 10, **characterized in that** this conductive wire crosses a separation zone with reduced solidity.

12. An electronic label according to Claims 1 to 11, **characterized in that** the rigid element (1) has means to produce the destruction of the chip (4) and/or the antenna (3) during the separation of the rigid element (1) from the flexible support (2).

13. An electronic label according to Claim 12, **characterized in that** these means consist of a glue placed between the chip (4) and the rigid element (1), and whose adhesive power is greater than that of the binding agent placed between the chip (4) and the flexible support (2).

14. An electronic label according to Claim 12, **characterized in that** the flexible support (2) has at least two orifices between which passes at least one of the conductors of the antenna (3), and **in that** these means comprise at least two spigots that are connected to the rigid element (1) and that cross said orifices, said spigots being widened at their ends either by adding a piece or by deformation.
